(19) Europäisches Patentamt
European Patent Office
Office européen des brevets

(11) **EP 3 615 707 B1**

(12) **EUROPEAN PATENT SPECIFICATION**

(45) Date of publication and mention
of the grant of the patent:
**05.01.2022 Bulletin 2022/01**

(21) Application number: **18719184.6**

(22) Date of filing: **26.04.2018**

(51) Int Cl.:
***C23C 16/26*** *(2006.01)*    ***C23C 16/40*** *(2006.01)*

(86) International application number:
**PCT/EP2018/060669**

(87) International publication number:
**WO 2018/197595 (01.11.2018 Gazette 2018/44)**

(54) **LAMINATED PACKAGING MATERIAL COMPRISING A BARRIER FILM**

LAMINIERTES VERPACKUNGSMATERIAL UMFASSEND EINE SPERRSCHICHTFOLIE

MATÉRIAU STRATIFIÉ COMPRENANT UN FILM DE BARRIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.04.2017 EP 17168833**

(43) Date of publication of application:
**04.03.2020 Bulletin 2020/10**

(73) Proprietor: **Tetra Laval Holdings & Finance S.A.**
**1009 Pully (CH)**

(72) Inventors:
• **LARRIEU, Jerome**
**1630 Bulle (CH)**
• **FAYET, Pierre**
**1006 Lausanne (CH)**

(74) Representative: **Tetra Pak - Patent Attorneys SE**
**AB Tetra Pak**
**Patent Department**
**Ruben Rausings gata**
**221 86 Lund (SE)**

(56) References cited:
**WO-A1-2017/005553**    **JP-A- 2005 088 452**
**JP-A- 2008 094 447**

**Description**

Technical field

The present invention relates to a laminated packaging material for liquid food products, comprising a durable barrier film, a first outermost liquid tight, heat sealable polyolefin layer and a second innermost liquid tight, heat sealable polyolefin layer, the durable barrier film having vapour deposited barrier coatings comprising an amorphous diamond-like carbon, DLC, coating.

Furthermore, the invention relates to a packaging container comprising the laminated packaging material or being made of the laminated packaging material.

Background of the invention

Packaging containers of the single use disposable type for liquid foods are often produced from a packaging laminate based on paperboard or carton. One such commonly occurring packaging container is marketed under the trademark Tetra Brik Aseptic® and is principally employed for aseptic packaging of liquid foods such as milk, fruit juices etc, sold for long term ambient storage. The packaging material in this known packaging container is typically a laminate comprising a bulk or core layer, of paper, paperboard or other cellulose-based material, and outer, liquid-tight layers of thermoplastics. In order to render the packaging container gas-tight, in particular oxygen gas-tight, for example for the purpose of aseptic packaging and packaging of milk or fruit juice, the laminate in these packaging containers normally comprises at least one additional layer, most commonly an aluminium foil.

On the inside of the laminate, i.e. the side intended to face the filled food contents of a container produced from the laminate, there is an innermost layer, applied onto the aluminium foil, which innermost, inside layer may be composed of one or several part layers, comprising heat sealable thermoplastic polymers, such as adhesive polymers and/or polyolefins. Also on the outside of the bulk layer, there is an outermost heat sealable polymer layer.

The packaging containers are generally produced by means of modern, high-speed packaging machines of the type that form, fill and seal packages from a web or from prefabricated blanks of packaging material. Packaging containers may thus be produced by reforming a web of the laminated packaging material into a tube by both of the longitudinal edges of the web being united to each other in an overlap joint by welding together the inner- and outermost heat sealable thermoplastic polymer layers. The tube is filled with the intended liquid food product and is thereafter divided into individual packages by repeated transversal seals of the tube at a predetermined distance from each other below the level of the contents in the tube. The packages are separated from the tube by incisions along the transversal seals and are given the desired geometric configuration, normally parallelepipedic, by fold formation along prepared crease lines in the packaging material.

The main advantage of this continuous tube-forming, filling and sealing packaging method concept is that the web may be sterilised continuously just before tube-forming, thus providing for the possibility of an aseptic packaging method, i.e. a method wherein the liquid content to be filled as well as the packaging material itself are reduced from bacteria and the filled packaging container is produced under clean conditions such that the filled package may be stored for a long time even at ambient temperature, without the risk of growth of micro-organisms in the filled product. Another important advantage of the Tetra Brik® -type packaging method is, as stated above, the possibility of continuous high-speed packaging, which has considerable impact on cost efficiency.

Packaging containers for sensitive liquid food, for example milk or juice, can also be produced from sheet-like blanks or prefabricated blanks of the laminated packaging material of the invention. From a tubular blank of the packaging laminate that is folded flat, packages are produced by first of all building the blank up to form an open tubular container capsule, of which one open end is closed off by means of folding and heat-sealing of integral end panels. The thus closed container capsule is filled with the food product in question, e.g. juice, through its open end, which is thereafter closed off by means of further folding and heat-sealing of corresponding integral end panels. An example of a packaging container produced from sheet-like and tubular blanks is the conventional so-called gable-top package. There are also packages of this type which have a moulded top and/or screw cap made of plastic.

A layer of an aluminium foil in the packaging laminate provides gas barrier properties quite superior to most polymeric gas barrier materials. The conventional aluminium-foil based packaging laminate for liquid food aseptic packaging is still the most cost-efficient packaging material, at its level of performance, available on the market today.

Any other material to compete with the foil-based materials must be cost-efficient regarding raw materials, have comparable food preserving properties and have a comparably low complexity in the converting into a finished packaging laminate.

Among the efforts of developing non-aluminium-foil materials for liquid food carton packaging, there is also a general incentive towards developing pre-manufactured films or sheets having high and multiple barrier functionalities, i.e. not only oxygen and gas barrier but also water vapour, chemical- or aroma-substance barrier properties, which may just replace the aluminium-foil barrier material, of the conventional laminated packaging material, and adapt it to the conventional Al-foil process for lamination and manufacturing.

One particular type of such alternative barrier material are barrier films made by vapour deposition coating onto polymer film substrates. Various vapour deposition processes and coating recipes for such processes, but there is a need for cost-efficient films of this type, having improved properties for use in packaging laminates for liquid food packaging, regarding barrier properties, in particular towards gases, such as oxygen gas, and in particular also regarding mechanical durability, since vapour deposited barrier coatings are, and need to be, quite thin.

Japanese patent application JP-A-2005088452 relates to gas barrier films having a first layer of DLC and a second layer of SiOx. It discloses good crack-onset strain properties of the barrier film. It mentions that the barrier films may be used in liquid paper containers and PECVD is mentioned as one suitable coating method among others.

Japanese patent application No. JP-A-2008094447 relates to rigid plastic containers or bottles, provided with an interior CVD coating with a first applied coating layer of DLC and a second applied coating layer of silicon oxide (SiOx or SiOxCy).

Disclosure of the invention

It is, accordingly, an object to provide improved barrier films and sheets for laminating into packaging materials.

It is also a general object to provide barrier films or sheets having good barrier properties and mechanical properties that fulfil the needs in liquid carton laminated packaging materials.

It is a further general object to provide packaging materials for oxygen-sensitive products, such as laminated packaging materials for liquid, semi-solid or wet food products, which do not contain aluminium foil but still have good gas and other barrier properties suitable for long-term, aseptic packaging at reasonable cost.

A particular object, is to provide a, relative to aluminium foil barrier materials, cost-efficient, non-foil, paper- or paperboard-based, laminated packaging material, having good gas and water vapour barrier properties, as well as mechanical durability for the purpose of manufacturing packages for long-term, aseptic food storage.

The object of the invention is to provide a cost-efficient, non-foil, paper- or paperboard-based and heat-sealable packaging laminate having good gas and water vapour barrier properties and good internal adhesion between the layers, for the purpose of manufacturing aseptic packaging containers for long-term storage of liquid foods at maintained nutritional quality under ambient conditions.

The object is thus attainable according to the present invention by the laminated packaging material and the packaging container as defined in the appended claims.

Summary of the invention

The invention is defined by the appended claims. According to a first aspect of the invention, the general objects are attained by using a barrier film in laminated packaging materials for liquid food products, the barrier film comprising a polymer film substrate and coated onto a first side of the polymer film substrate, by plasma-enhanced chemical vapour deposition (PECVD) in a vacuum process, a first coating layer of silicon oxide having the general composition formula SiOxCy, wherein x is from 1.5 to 2.2, and y is from 0.15 to 0.8, a second coating layer of an amorphous diamond-like carbon (DLC), which is directly adjacent and contacting the first coating layer, and wherein the total thickness of the first and second coating layers is from 7 to 10 nm, the barrier film providing gas and water vapour barrier properties and mechanical durability in a packaging material and packages made thereof.

The first coating layer of silicon oxide may have the general composition formula SiOxCy, wherein x is from 1.7 to 2.1 and y is from 0,39 to 0.47.

By such a barrier film, obtained by a PECVD-coating process under vacuum, a balance of properties may be obtained, which is highly suitable for laminated packaging materials and liquid-food packaging containers made therefrom. In particular, such PECVD coating layers have good quality and may complement one another in a synergistic manner, such that a thinner total coating may provide equal or better gas barrier properties but with improved mechanical durability, as defined by crack-onset strain, measured as the strain at which the oxygen transmission rate increases significantly, such that the barrier function of the film deteriorates and disappears. Furthermore, by a barrier film consisting of only two thin coatings, together forming a well-functioning thin total barrier, both towards oxygen gas and water vapour, the coating process may be more cost efficient due to a higher coating speed being possible, and there will be lower amounts of further materials in the laminated packaging material, beyond the necessary paperboard and polymer layers in liquid carton packaging.

The laminated packaging material further comprises a first outermost liquid tight, heat sealable polyolefin layer and a second innermost liquid tight, heat sealable polyolefin layer.

In a second aspect of the invention there is provided a packaging container comprising the laminated packaging material of the invention, intended for packaging of liquid, semi-solid or wet food. According to an embodiment, the packaging container is manufactured from the laminated packaging material of the invention, and according to a further embodiment it is in its entirety made of the laminated packaging material.

The method of manufacturing the barrier film, comprises a first step of providing a polymer film substrate as a forward moving web surface in a roll to roll system,

a second step of depositing a first coating layer of a silicon oxide having the general formula SiOxCy, wherein x is from 1.5 to 2.2 and y is from 0.15 to 0.8, onto the moving polymer film substrate, by subjecting an organosilicon gas precursor to a vacuum plasma in a PECVD coating operation,

a third step of further depositing onto the first coating layer on the moving polymer film substrate, a second coating layer of an amorphous diamond-like carbon, DLC, by subjecting a hydrocarbon gas precursor to a vacuum plasma in a PECVD coating operation.

The method may further comprise a fourth step carried out before the second step, of depositing a pre-coating layer of an amorphous diamond-like carbon, DLC, onto the moving polymer film substrate, by subjecting a hydrocarbon gas precursor to a vacuum plasma in a PECVD coating operation.

The barrier film obtained by the above method and coating layer configuration, shows excellent barrier properties, such as low OTR, low WVTR, good aroma and odour barrier properties as well as good chemical resistance, and proves to have good mechanical properties in subsequent handling operations such as lamination into a laminated packaging material and the fold-forming and sealing operations of such a laminated material into packages. The good mechanical properties are believed to relate to the durability of the combination of coatings, each contributing individually but together resulting in a surprisingly improved barrier film, indicating that there is good cohesion within the deposited barrier coatings, as well as good adhesion and bonding of the coating layers to the surface of the polymer film substrate. An important indicator of good mechanical properties, as useful for liquid packaging, is the crack-onset-strain, COS, i.e. the strain of the barrier film, at which the oxygen barrier properties begin to deteriorate.

Detailed description

With the term "long-term storage", used in connection with the present invention, is meant that the packaging container should be able to preserve the qualities of the packed food product, i.e. nutritional value, hygienic safety and taste, at ambient conditions for at least 1 or 2 months, such as at least 3 months, preferably longer, such as 6 months, such as 12 months, or more.

With the term "package integrity", is generally meant the package tightness, i.e. the resistance to leakage or breakage of a packaging container. In particular, it encompasses the resistance of the package to intrusion of microbes, such as bacteria, dirt, and other substances, that may deteriorate the filled food product and shorten the expected shelf-life of the package.

One main contribution to the integrity of a package from a laminated packaging material is provided by good internal adhesion between adjacent layers of the laminated material. Another contribution comes from the material resistance to defects, such as pinholes, ruptures and the like within each material layer itself, and yet another contribution comes from the strength of the sealing joints, by which the material is sealed together at the formation of a packaging container. Regarding the laminated packaging material itself, the integrity property is thus mainly focused on the adhesion of the respective laminate layers to its adjacent layers, as well as the quality of the individual material layers. Regarding the sealing of the packages, the integrity is mainly focussed on the quality of the sealing joints, which is ensured by well-functioning and robust sealing operations in the filling machines, which in turn is ensured by adequately adapted heat-sealing properties of the laminated packaging material.

The term "liquid or semi-liquid food" generally refers to food products having a flowing content that optionally may contain pieces of food. Dairy and milk, soy, rice, grains and seed drinks, juice, nectar, still drinks, energy drinks, sport drinks, coffee or tea drinks, coconut water, wine, soups, jalapenos, tomatoes, sauce (such as pasta sauce), beans and olive oil are some nonlimiting example of food products contemplated.

The term "aseptic" in connection with a packaging material and packaging container refers to conditions where microorganisms are eliminated, in-activated or killed. Examples of microorganisms are bacteria and spores. Generally an aseptic process is used when a product is aseptically packed in a packaging container. For the continued asepticity during the shelf-life of the package, the package integrity properties are of course very important. For long-term shelf-life of a filled food product, it may furthermore be important that he package has barrier properties towards gases and vapours, such as towards oxygen gas, in order to keep its original taste and nutritional value, such as for example its vitamin C content.

With the term "bulk layer" is normally meant the thickest layer or the layer containing the most material in a multilayer laminate, i.e. the layer which is contributing most to the mechanical properties and the dimensional stability of the laminate and of packaging containers folded from the laminate, such as paperboard or carton. It may also mean a layer providing a greater thickness distance in a sandwich structure, which further interacts with stabilising facing layers, which have a higher Young's modulus, on each side of the bulk layer, in order to achieve sufficient such mechanical properties and dimensional stability.

The crack onset strain, COS, is the point of elongation where a coating cracks, leaving passages for oxygen to diffuse through the barrier film. The mechanical properties in terms of cohesion and and interfacial shear strength of thin coatings can be studied by observing the evolution of fragmentation patterns of the coating under uniaxial load by in-situ atomic force microscopy (AFM). The behaviour of a coating/substrate system can be described in two steps. First, as the stress in the coating reaches its cohesive strength, the first cracks are observed which propagate perpendicularly to the tensile direction. This defines the crack onset strain. Second, as the nominal strain is further increased, the crack density increases and finally reaches a saturation level which is determined by the capacity of the interface to transfer the stress from the substrate to the coating. The interfacial shear strength between the coating and the substrate, can be determined from the saturation level of the crack density. However, also the oxygen transmission rate evolution of a barrier film under strain directly provides a measurement of the crack onset strain of coatings.

Thickness measurements were performed by Transmission Electronic Microscopy using a Titan 80-300, FEI equipment. Samples are prepared by ultramicrotomy on an EM UC6 Microtome from Leica.

OTR was measured with Oxtran 2-60 (Mocon Inc.) equipment based on coulometric sensors, with a standard deviation of the results being $\pm 0,5$ cm$^3$/m$^2$/day.

The method for determining OTR identifies the amount of oxygen per surface and time unit at passing through a material at a defined temperature, given atmospheric pressure, and chosen driving force.

Water vapour transmission rate (WVTR) measurements were carried out by a Lyssy instrument (norm: ASTM F1249-01 using a modulated Infrared sensor for relative humidity detection and WVTR measurement) at 38°C and 90% driving force. This test method is dedicated to measure Water Vapor Transmission Rate (WVTR) properties of films. The procedure is done according to ASTM F1249-01 using a modulated Infrared sensor for relative humidity detection and WVTR measurement.

The substrate material itself may contribute with some properties as well, but should above all have appropriate surface properties, suitable for receiving a vapour deposition coating, and for working efficiently in a vapour deposition process. The web substrate can be a single-layered or multi-layered film. A multi-layered film particularly has a substrate surface polymer layer.

The web substrate, i.e. the single layer polymer film or the substrate surface layer of the multilayer polymer film may be selected from the group consisting of films based on polyethylene terephthalate (PET), mono- or biaxially oriented PET (OPET, BOPET), non- or mono- or biaxially oriented polyethylene furanoate (PEF), oriented or non-oriented polybutylene terephthalate (PBT), polyethylene napthanate (PEN), polyamide, non-oriented or oriented polyamide (PA, OPA, BOPA), polyolefins such as polypropylene, mono- or biaxially oriented polypropylene (PP, OPP, BOPP), polyethylenes such as oriented or non-oriented high density polyethylene (HDPE), linear low density polyethylene (LLDPE) and cyclo-olefin co-polymers (COC), or on blends of two or more of said polymers, or on multilayer films having a surface layer comprising such polymers or blends thereof.

It is also conceivable that polymer film substrates from polymers of plant or vegetable origin may be used, such as films based on, or having surface layers of, cellulose derivatives, starch or other polysaccharides or their derivatives.

More specifically, the polymer film substrate may be a film selected from the group consisting of films based on polyethylene terephthalate (PET), mono- or biaxially oriented PET (OPET, BOPET), polybutylene terephthalate (PBT), polyethylene naphthanate (PEN), non-oriented polyamide, oriented polyamide (PA, OPA, BOPA), or on blends of two or more of said polymers, or on multilayer films having a surface layer comprising such polymers or blends thereof. According to an embodiment, the polyamide is selected from a the group consisting of aliphatic polyamides, such as polyamide 6 or polyamide 6,6, semi-aromatic polyamides, such as nylon-MXD6 or Selar, or blends of aliphatic and semi-aromatic polyamides.

Even more specifically, the polymer film substrate may be an oriented PET film.

The polymer film substrate, such as the oriented PET film, has a thickness of 12 $\mu$m or lower, such as from 8 to 12 $\mu$m, such as 12 $\mu$m.

Thinner polymer film substrates do exist commercially and would be feasible within the scope of the present invention, but it is presently not realistic to go below 8 $\mu$m, and films thinner than 4 $\mu$m would be difficult from a web-handling point of view in industrial coating and lamination processes for packaging. On the other hand, films thicker than 12-15 $\mu$m are of course feasible but less interesting for laminated packaging materials of the invention from a cost-efficiency view, and also since they add too much strength and toughness for the functionality of opening devices and perforations. According to an embodiment, the polymer film substrate should be 12 $\mu$m or below, such as an oriented PET film of from 10 to 12 $\mu$m, such as about 12 $\mu$m. At higher thickness of the film substrate, the tearing and cutting properties of the laminated packaging material are impaired because of the higher strength of the material. Oriented films usually exhibit an increased strength and toughness against tearing or cutting through the film, and when included in laminated packaging materials such films can cause difficulties in opening of a package. By selecting as thin as possible polymer film substrates, the openability of a subsequently laminated packaging material will not be impaired, in comparison to laminated packaging materials in which the barrier materials are more brittle and the polymer materials are entirely made by melt extrusion coating and melt extrusion lamination.

PET films are robust and cost efficient films with good mechanical properties, and this makes them particularly suitable substrates for DLC vapour deposition coating and also due to some inherent high temperature resistance and relative resistance to chemicals and moisture. The surface of a PET film also has high smoothness and good affinity to vapour deposited DLC coatings and vice versa.

The polymer film substrate, such as a BOPET film, may have an adhesion-promoting primer coating on its other side, opposite the side coated with the first and second coating layers. The purpose of the adhesion-promoting primer coating is to provide better bonding to adjacent layers on both sides of the barrier film, when laminating the film into a laminated packaging material. For example, it makes it possible to create or improve the adhesion strength to an adjacent extrusion-coated polymer, such as a polyolefin-based polymer layer and the contacting surface thereof.

The adhesion-promoting primer coating may be a composition comprising a compound selected from the group of aminosilanes and polyethyleneimines. A particular example of a primer suitable for the purpose of the invention is the 2DEF® primer used on the Hostaphan® RNK12 BOPET film from Mitsubishi, as used in the examples hereinafter.

Alternatively, the adhesion-promoting primer coating may be a further (fourth) coating of an amorphous diamond-like coating (DLC). Such an adhesion-promoting primer DLC coating, may be applied as a very thin coating, such as at a thickness from 2 to 50 nm, such as from 2 to 10 nm, such as from 2 to 5 nm.

The total thickness of the first and second barrier coating layers may be quite low, such as 10 nm or lower, such as 9 nm or lower, such as 8 nm or lower.

The silicon oxide coating may be applied to a thickness of from 3 to 8 nm, such as from 3 to 7 nm, such as from 3 to 6 nm, such as from 3 to 5 nm.

The durable DLC barrier coating may be deposited to a thickness of from 2 to 5 nm, such as from 2 to 4, such as from 2 to 3 nm.

The durable barrier film obtained by the above method, shows excellent barrier properties, such as low OTR, low WVTR, good aroma and odour barrier properties as well as good chemical resistance, and proves to have good mechanical properties in subsequent handling operations such as lamination into a laminated packaging material and the fold-forming and sealing operations of such a laminated material into packages. The excellent mechanical properties are believe to be explainable by the durability of the combination of coating layers, each contributing individually but together resulting in a surprisingly improved barrier film, meaning that there is good cohesion within the deposited barrier coating layers, as well as good adhesion and bonding between the coating layers and to the surface of the polymer film substrate. An important indicator of good mechanical properties, as useful for liquid packaging, is the crack-onset-strain, COS, i.e. the strain of the barrier film, at which the oxygen barrier properties begin to deteriorate.

Regarding PET-based films, a COS of about 2% or above, may be obtained with a good amorphous DLC coating by PECVD under vaccum. With a good silicon oxide coating, having a general composition formula SiOx or SiOxCy wherein x is from 1.5 to 2.2, and y is from 0.15 to 0.8, by PECVD under vacuum, a COS of about 3-4 % may be obtained by coating onto a similar film. However, when vacuum-coating by PECVD a similar PET-based film with a first coating of the same SiOxCy, followed by a coating of amorphous DLC, the COS is synergetically improved to a value of 5-6 % and above, and in addition, the total coating thickness may be thinner, while still achieving the same level of barrier properties as compared to comparable, but thicker, single-layer coatings.

In order to achieve meaningful oxygen barrier properties of a single deposition coating layer of an amorphous DLC film, it has been observed that a thickness of the coating layer of at least 10, such as at least 13 nm, and in many cases of at least above 20 nm is needed.

Correspondingly, in order to achieve meaningful oxygen barrier properties of a single deposition coating layer of an silicon oxide of the general composition formula SiOxCy, it has been observed that a thickness of the coating layer of at least 10, and in many cases of at least 20 nm is needed.

According to the invention, a laminated packaging material comprising the barrier film is thus provided. The laminated packaging material further comprises a first outermost liquid tight, heat sealable polyolefin layer and a second innermost liquid tight, heat sealable polyolefin layer.

The laminated packaging material may comprise a bulk layer of paper or paperboard, a first outermost liquid tight, heat sealable polyolefin layer, a second innermost liquid tight, heat sealable polyolefin layer and, arranged on the inner side of the bulk layer of paper or paperboard, towards the inside of a packaging container made from the packaging material, between the bulk layer and the innermost layer, said barrier film.

The barrier sheet or film may be bonded to the bulk layer by an intermediate adhesive, or thermoplastic polymer bonding layer, thus binding the surface of the second DLC coating of the barrier film to the bulk layer. According to a special embodiment the bonding layer is a polyolefin layer, such as in particular a layer of a polyethylene-based polyolefin copolymer or blend, including in the majority ethylene monomer units. Preferably, the bonding layer is binding the bulk layer to the barrier film by melt extrusion laminating the bonding polymer layer between a web of the bulk layer and a web of the film layer, and simultaneously pressing the three layers together while being forwarded through a lamination roller nip, thus providing a laminated structure, i.e. by so-called extrusion laminating the bulk layer to the barrier film.

According to a further embodiment, the polymer film substrate of the barrier film has an adhesion-promoting primer coating on its other side, opposite the side coated with the single-layer gradient durable DLC barrier coating, and the barrier film is bonded to the second innermost liquid tight, heat sealable polyolefin layer by means of the adhesion-promoting primer coating.

It has been seen that the laminated packaging material according to the invention has excellent integrity, by providing excellent adhesion between the adjacent layers within the laminated construction and by providing good quality of the barrier coating. Especially, for the packaging of liquids, and wet food, it is important that the inter-layer adhesion within the laminated packaging material is maintained also under wet packaging conditions. Among various types of vapour deposition barrier coatings, it has been confirmed that this configuration of vapour deposited barrier coatings, applied by means of plasma enhanced chemical vapour deposition, PECVD, has excellent laminate integrity properties. Barrier coatings from other types of vapour deposition chemistry, such as SiOx or AlOx coatings, do not, on the other hand, show good integrity properties in a laminated material of the same kind under wet and humid conditions. This extraordinary adhesion compatibility of the amorphous DLC coating to organic polymers, such as in particular polyolefins, also under wet conditions was unexpected and surprising, and makes such barrier films particularly suitable for liquid packaging.

In another embodiment, the barrier film of the laminated packaging material may be a double barrier film, which comprises a first barrier film being laminated and bonded to a further identical or similar second barrier film by means of an interjacent thermoplastic bonding layer. The barrier coatings may be facing towards each other with the interjacent thermoplastic bonding layer in between. Alternatively, the barrier coatings may be facing away from each other, such that the adhesion-promoting primer coatings are bonded to each other by the the interjacent thermoplastic bonding layer. A further alternative is to stack the two films to each other such that both barrier coatings are facing in the same direction. The double barrier film may be further laminated to a bulk layer, such as a paper or paperboard or other cellulose-based material.

In a further embodiment, a first barrier film is laminated and bonded to a further identical or similar second barrier film by means of an interjacent thermoplastic bonding layer, the laminated packaging material further comprising a first outermost liquid tight, heat sealable polymer layer on the opposite, not laminated side of the first barrier film and a second innermost liquid tight, heat sealable polymer layer on the opposite, not laminated side of the second barrier film.

In a second aspect of the invention there is provided a packaging container comprising the laminated packaging material of the invention, intended for packaging of liquid, semi-solid or wet food. According to an embodiment, the packaging container is manufactured from the laminated packaging material of the invention, and according to a further embodiment it is in its entirety made of the laminated packaging material.

According to a still further embodiment, the packaging container may be formed from the laminated packaging material partly sealed, filled with liquid or semi-liquid food and subsequently sealed, by sealing of the packaging material to itself, optionally in combination with a plastic opening or top part of the package.

Over time, various vapour deposition barrier coatings have been considered in designing packaging materials that fulfil the gas barrier criteria as well as the needs of various mechanical and other physical properties.

Vapour deposited barrier layers may be applied by means of physical vapour deposition (PVD) or chemical vapour deposition (CVD) onto a substrate surface of a film material.

Thin vapour deposited layers are normally merely nanometer-thick, i.e. have a thickness in the order of magnitude of nanometers, for example of from 1 to 500 nm (50 to 5000 Å), preferably from 1 to 200 nm, more preferably from 1 to 100 nm and most preferably from 1 to 50 nm.

One common type of vapour deposition coating, often having some barrier properties, in particular water vapour barrier properties, are so called metallisation coatings, e.g. aluminium metal physical vapour deposition coatings.

Such a vapour deposited layer, substantially consisting of aluminium metal may have a thickness of from 5 to 50 nm, which corresponds to less than 1 % of the aluminium metal material present in an aluminium foil of conventional thickness for packaging, i.e. 6,3 $\mu$m. While vapour deposition metal coatings require significantly less metal material, they only provide a low level of oxygen barrier properties, at most, and need to be combined with a further gas barrier material in order to provide a final laminated material with sufficient barrier properties. On the other hand, it may complement a further gas barrier layer, which does not have water vapour barrier properties, but which is rather sensitive to moisture.

Other examples of vapour deposition coatings are aluminium oxide (AlOx, $Al_2O_3$) and silicon oxide (SiOx) coatings. Generally, such PVD-coatings are more brittle and less suitable for incorporation into packaging materials by lamination, while metallised layers as an exception do have suitable mechanical properties for lamination material despite being made by PVD.

Other coatings may be applied by means of a plasma enhanced chemical vapour deposition method (PECVD), wherein a vapour of a compound is deposited onto the substrate under more or less oxidising circumstances. Silicon oxide coatings (SiOx) may, for example, also be applied by a PECVD process, and may then obtain very good barrier properties under certain coating conditions and gas recipes. Unfortunately, SiOx coatings show bad adhesion properties when laminated by melt extrusion lamination to polyolefins and other adjacent polymer layers. Special expensive adhesives or adhesive polymers are needed to reach sufficient adhesion in a packaging laminate of the type intended for liquid carton packaging. Furthermore, the mechanical properties of PECVD SiOx-coated films, as with the other single-layer vapour deposition coatings, still may be improved to endure lamination and package forming better, since the coatings are very sensitive and thin in comparison to aluminium foil of several $\mu$m thickness. One type of silicon oxide coating, having both gas barrier and water vapour barrier properties also at higher humidity levels, as required in liquid packaging, as well as improved compatitbility with adjacent layers in a multilayer structure, has the general composition formula SiOxCy, where in x is from 1.5 to 2.2 and y is from 0.15 to 0.8. The crack onset strain of such SiOxCy PECVD coating layers onto polymer films normally varies from about 3 to about 4 %, depending i.a. on the choice of polymer film substrate and coating thickness. Such coatings have been described in applicant's earlier patent application US2002/0028336, describing that a method of pre-straining the substrate film during the coating operation may increase the point of crack onset strain to some extent.

DLC defines a class of amorphous carbon material (diamond-like carbon) that displays some of the typical properties of diamond. Preferably, a hydrocarbon gas, such as e.g. acetylene or methane, is used as process gas in a plasma for producing a coating of amorphous hydrogenated carbon barrier layer applied by a PECVD vacuum process, i.e. a DLC. DLC coatings applied by PECVD under vacuum provide good adhesion to adjacent polymer or adhesive layers in a laminated packaging material. Particularly good adhesion to adjacent polymer layers, are obtained with polyolefins and in particular polyethylene and polyethylene-based co-polymers. The crack onset strain for such DLC coatings at most reach values of slightly above 2 %, however.

The barrier coated barrier film of the invention has excellent gas barrier and water vapour barrier properties, as well as a high crack onset strain (COS), which is a measure of how the oxygen barrier properties deteriorate with increased strain of a coated barrier film. The measurement of COS is an indirect indication of the mechanical strength and durability of the coated barrier film, including properties such as adhesion of the barrier coatings to the polymer film substrate and the cohesion within the barrier coatings themselves. This mechanical strenght and durability is useful and needed when the barrier film is laminated into multilayer packaging materials and further converted from the laminated packaging material into foldformed, filled and sealed packaging containers.

The patent publication US 7,806,981 discloses an example of a device and method for continuously coating a web substrate in a vacuum PECVD process. The device comprises a coating station with a vacuum chamber and within the vacuum chamber a rotating drum which supports and transports the web substrate and which forms a counter-electrode. A web of sheet or film substrate is thus un-wound from a roll and forwarded by travelling over a rotating drum, passing by the plasma reaction and coating zone of the reactor, and re-wound onto a roll on the other side of the drum. The device further comprises a plurality of magnetron electrodes on the periphery of the rotating drum. The magnetron electrodes are facing the surface of the web substrate. The device further comprises means for supplying a process gas to the space between the rotating drum and the magnetron electrodes. The magnetron electrodes are suitably powered with an alternating voltage at 40-50 kHz. The plasma is capacitively coupled to the power, and magnetically confined by the magnetron electrodes placed at a pre-determined distance from and around the drum electrode and its circumferential surface.

The rotating drum is according to an embodiment cooled, in order to keep sensitive substrates at a constant temperature. According to an embodiment, the polymer film substrate is cooled to a constant temperature of 10 degrees Celsius or lower.

The substrate is moved through the plasma zone at a constant speed, by being carried and transported by the drum, the speed being regulated by the drum rotational speed.

According to an embodiment, the magnetron electrodes may be individually powered, in order to enable better control of the process and a uniform plasma across the whole plasma reaction zone.

According to an embodiment, a pre-treatment of the substrate surface, with argon, nitrogen or oxygen plasma or a mixture of one or more thereof, is preceding the plasma coating operation, in order to get the right interface between the polymer film substrate and the first coating.

Another example of a vacuum PECVD coating apparatus may involve a radio frequency antenna, which is excited by an RF generator to creating a plasma reaction zone being inductively coupled to the power. The antenna and web roll-to-roll supply of the film substrate is arranged such that coating of the film surface can take place.

The first and second coating layers of the invention may be applied by consecutive coating operations in one and a same reaction apparatus or in a multi-chamber apparatus, wherein each chamber has a separately controlled plasma space.

Since the total coating thickness of the first and second coating layers is only 10 nm or lower, such as typically from 7 to 9 nm, but still achieveing the desired and required barrier properties, the coating speed and efficiency may be high. The first coating layer of silicon oxide may be from 4 to 8 nm thick, and thicker than the second DLC coating layer, which may be from 2 to 4 nm thick.

The first and second barrier coating layers further have the advantage of being recyclable, without leaving residues that in the recycled content that contain elements or materials that are not naturally existing in nature and our surrounding environment.

According to an aspect of the invention, the durable barrier film is thus included in a laminated material suitable for packaging, whereby it is laminated to heat sealable, liquid-tight, polyolefin layers on both sides.

Suitable thermoplastics for the outermost and innermost heat sealable liquid-tight layers are polyolefins such as polyethylene and polypropylene homo- or co-polymers, preferably polyethylenes and more preferably polyethylenes selected from the group consisting of low density polyethylene (LDPE), linear LDPE (LLDPE), single site catalyst metallocene polyethylenes (m-LLDPE) and blends or copolymers thereof. According to a preferred embodiment, the outermost heat sealable and liquid-tight layer is an LDPE, while the innermost heat sealable, liquid-tight layer is a blend composition of m-LLDPE and LDPE for optimal lamination and heat sealing properties.

The same thermoplastic polyolefin-based materials, as listed regarding the outermost and innermost layers, and in particular polyehtylenes, are also suitable in bonding layers interior of the laminated material, i.e. between a bulk or core layer, such as paper or paperboard, and the barrier film. In an embodiment, the thermoplastic bonding layer may be a polyethylene layer, such as a low density polyethylene (LDPE) layer.

According to an alternative embodiment, suitable bonding or tie layers interior of the laminated material, such as for example between the bulk or core layer and the barrier film, or between the outer heat sealable layer and the barrier- or primer-coated polymer film substrate, are also so-called adhesive thermoplastic polymers, such as modified polyolefins, which are mostly based on LDPE or LLDPE co-polymers or, graft co-polymers with functional-group containing monomer units, such as carboxylic or glycidyl functional groups, e.g. (meth)acrylic acid monomers or maleic anhydride (MAH) monomers, (i.e. ethylene acrylic acid copolymer (EAA) or ethylene methacrylic acid copolymer (EMAA)), ethylene-glycidyl(meth)acrylate copolymer (EG(M)A) or MAH-grafted polyethylene (MAH-g-PE). Another example of such modified polymers or adhesive polymers are so called ionomers or ionomer polymers. Preferably, the modified polyolefin is an ethylene acrylic acid copolymer (EAA) or an ethylene methacrylic acid copolymer (EMAA).

Corresponding modified polypropylene-based thermoplastic adhesives or bonding layers may also be useful, depending on the requirements of the finished packaging containers.

Such adhesive polymer layers or tie layers are applied together with the respective outer layer in a co-extrusion coating operation.

However, normally, the use of the above described adhesive polymers should not be necessary for bonding to the DLC barrier coating of the invention. Sufficient and adequate adhesion to polyolefin layers, and in particular to polyethylene layers, as adjacent layers have been concluded, at a level of at least 200 N/m, such as at least 300 N/m.

Adhesion measurements are performed at room temperature with a 180° degrees peel force test apparatus (Telemetric Instrument AB), 24 h after the LDPE lamination. Peeling is performed at the DLC/LDPE interface, the peel arm being the barrier film. When needed, distilled water droplets are added to the peeled interface during peeling to assess the adhesion under wet conditions, i.e. the conditions when the laminated packaging material has been saturated with migrating moisture through the material layers, from the liquid stored in a packaging container made from the laminated material, and/or by storage in a wet or highly humid environment.The given adhesion value is given in N/m and is an average of 6 measurements.

A dry adhesion of more than 200 N/m ensures that the layers do not delaminate under normal package manufacturing conditions, e.g. when bending and fold-forming the laminated material. A wet adhesion of this same level ensures that the layers of the packaging laminate do not delaminate after filling and package formation, during transport, distribution and storage.

The interior bonding polymer layer may be coated directly onto the polymer film substrate having the second DLC barrier layer coated thereon, by using common techniques and machines, e.g. those known for the lamination of an aluminum foil, in particular hot lamination (extrusion) of the polymer layer from a molten polymer. Also, using a premade polymer film and binding it directly to the barrier-coated carrier film by locally melting it, e.g. by applying heat with a hot cylinder or heated roller, is possible.

From the above it is apparent that the barrier film can be handled in a similar way to an aluminium foil barrier in the lamination and conversion methods into a laminated packaging material. The lamination equipment and methods do not require any modification, by for example adding specific adhesive polymers or binder/tie layers as may be required in previously known plasma coated materials. In addition, the new barrier film including the durable DLC barrier layer coated thereon can be made as thin as an aluminium foil without adversely affecting the barrier properties in the final food package.

It has been seen that when laminating the second DLC barrier coating surface to an adjacent layer of e.g. polyethylene, such as LDPE, the contributing oxygen barrier properties from the barrier film are increased to a 2-3 times higher value than by measuring on the barrier film itself, only. This barrier improvement by merely laminating the barrier film of the invention into a laminate, cannot be explained by a simple laminate theory, according to which

$$1/OTR = SUMi(1/OTRi)$$

but does, thus, improve the total barrier beyond the individual contribution of OTR by each laminate layer. It is believed that it is the excellent adhesion between the DLC coating and the polyolefin surface that leads to a particularly well integrated interface between the two materials, and thereby to improved oxygen barrier properties.

In a preferred embodiment of the invention, the peel force strength between the second DLC barrier coating layer and the further, laminating, bonding polymer layer as measured by a 180° peel test method under dry and wet conditions (by putting water at the peeling interface)) (as described above) is higher than 200 N/m, such as higher than 300 N/m. A dry adhesion of more than 200 N/m ensures that the layers do not delaminate under normal manufacturing conditions, e.g. when bending and fold-forming the laminated material. A wet adhesion of the same level ensures that the layers of the packaging laminate do not delaminate after filling and package formation, during transport, distribution and storage.

To conlude, improved packages for long term shelf-life and storage liquid food packaging are obtained by the barrier film and the laminated packaging material comprising the film, as defined by the invention, due to the improved mechanical durability properties of the barrier film itself, and from its improved functioning when laminated into a packaging laminate structure. The laminated packaging material structure works better for the forming into fold-formed packages, both from the improved adhesion between material layers and from the improved mechanical durability of the barrier film itself, in turn thanks to improved cohesion of barrier coating layers in combination with improved adhesion between the coating layers ot the polymer film substrate.

Examples and description of preferred embodiments

In the following, preferred embodiments of the invention will be described with reference to the drawings, of which:

Fig. 1a schematically shows a barrier film according to the invention in cross-section, coated with first and second barrier coating layers,
Fig. 1b shows a similar barrier film having a further pre-coating layer,
Fig. 1c schematically shows a similar barrier film, comprising a polymer film substrate which has been coated also on its opposite side with a DLC coating functioning as an adhesion-promoting layer,
Fig. 2a is showing a schematic, cross-sectional view of a laminated packaging material according to the invention, comprising the barrier film of Fig. 1a,
Fig. 2b is showing a schematic, cross-sectional view of a further laminated packaging material comprising the barrier film of Fig. 1c,
Fig. 3 shows schematically a method, for laminating the durable barrier film of the invention into a laminated packaging material for liquid packaging, having a core or bulk layer of paperboard or carton,
Fig. 4 is showing a diagrammatic view of a plant for plasma enhanced chemical vapour deposition (PECVD) coating, by means of a magnetron plasma, onto a substrate film,
Fig. 5a, 5b, 5c and 5d are showing typical examples of packaging containers produced from the laminated packaging material according to the invention,
Fig. 6 is showing the principle of how such packaging containers are manufactured from the packaging laminate in a continuous, roll-fed, form, fill and seal process,
Fig. 7 shows a diagram of comparable barrier films, one of which is according to the invention.

Examples

A 12 $\mu$m thick film of biaxially oriented polyethyleneterephthalate (BOPET Hostaphan RNK12 by Mitsubishi) was deposition coated in a roll-to-roll plasma reactor, by plasma enhanced chemical vapour deposition (PECVD) under vacuum conditions.

One film sample was coated according to the invention, i.e. with a first coating layer of SiOxCy, wherein x is from 1.5 to 2.2, and y is from 0.15 to 0.8, and a second coating layer of an amorphous DLC. The total thickness of the two coating layers was determined to be from 8 nm. A comparison film sample was coated with a single coating of SiOxCy, wherein x is from 1.5 to 2.2, and y is from 0.15 to 0.8, preferably from 0.39 to 0.47. The single SiOxCy coating was deposited to a thickness of about 20 nm. A further comparison film sample was deposition coated with DLC to a thickness of 13.7 nm. The OTR as a function of the percentage of strain of each barrier film is shown in the diagram, and the point where the OTR completely takes off above useful levels, like about 10 cc/m$^2$/day/atm at 23 °C and 50% RH.

Examples - adhesion to laminated layers

Films from 12 μm thick biaxially oriented polyethyleneterephthalate (BOPET Hostaphan RNK12 and RNK12-2DEF by Mitsubishi) were deposition coated with various coatings by plasma enhanced chemical vapour deposition (PECVD) under vacuum conditions, in a roll-to-roll plasma reactor. A diamond-like amorphous hydrogenated carbon coating, DLC, was coated on some film samples, in line with the invention, while other PECVD barrier coatings were coated on other samples. The other PECVD barrier coatings, subject of comparative examples, were SiOx, wherein x varied between 1,5 and 2,2, SiOxCy coatings and SiOxCyNz coatings, respectively. These other silicon-containing barrier coatings were formed from organosilane pre-cursor gas compounds. The film samples according to the invention, were coated by depositing an amorphous, hydrogenated diamond-like coating DLC from a plasma formed from pure acetylene gas.

The plasma employed was capacitively coupled to the power delivered at 40 kHz frequency, and magnetically confined by unbalanced magnetron electrodes placed at a distance from the circumferential surface of a rotating drum, which functioned as a combined film-web transporting means and electrode. The polymer film substrate was cooled by cooling means within the drum web-transporting means.

The DLC coating was in a first example applied to a thickness of about 15-30 nm, and in a second example to a thickness of only about 2-4 nm.

The SiOx coatings were coated to a thickness of about 10 nm.

The thus barrier-coated substrate film samples, were subsequently extrusion coated with a 15 g/m2 thick layer of low density polyethylene (LDPE), of a type corresponding to LDPE materials of the laminate bonding layer that is conventionally used in order to extrusion laminate paperboard to aluminium foil in liquid carton packaging laminates.

The adhesion between the thus extrusion coated LDPE layer and the barrier-coated substrate PET film, was measured by a 180°peel test method under dry and wet conditions (by putting distilled water at the peeling interface) as described above. An adhesion of more than 200 N/m ensures that the layers do not delaminate under normal manufacturing conditions, e.g. when bending and fold-forming the laminated material. A wet adhesion of this same level ensures that the layers of the packaging laminate do not delaminate after filling and package formation, during transport, distribution and storage.

Table 1

| Coating type | Oxygen Barrier | Water Vapour Barrier | PE-laminate Peel force (N/m) Dry adhesion | PE-laminate Peel force (N/m) wet adhesion |
|---|---|---|---|---|
| SiOx (x= 1,5-2,2) | < 3cc at 3 6 Mean 1.5 cc | N/A | 40-50 | 0 |
| SiOxCy | < 3cc at 3 6 Mean 1.5 cc | 1 | 40-50 | 40-50 |
| SiOxCyNz | < 3cc at 3 6 Mean 1.5 cc | 1 | 200-300 | 100 |
| DLC ~25 nm | < 3cc at 3 6 Mean 1.5 cc | 0.8 | 350-400 | 350-400 |
| DLC ~25 nm on both sides of film | 0.5 ± 0.05 | 0.5 | 350-400 | 350-400 |
| DLC 2-4 nm | 60-80 | 5-6 | 350-400 | 350-400 |
| DLC 2-4 nm on both sides of film | 60-80 | 5-6 | 350-400 | 350-400 |

As can be seen from the results summarised in Table 1, there is some insufficient dry adhesion between pure SiOx barrier coatings and there onto extrusion coated LDPE, while the adhesion deteriorates completely under wet/humid conditions.

When experimenting with more advanced SiOx formulas, containing also carbon and nitrogen atoms, some improvement is seen in the dry and/or wet adhesion properties, as compared to the pure SiOx coating, but the wet adhesion properties remain insufficient, i.e. below 200 N/m.

The dry adhesion of a DLC coating to extrusion coated LDPE is slightly better than for the best of the tested SiOxCyNz coatings. The more important and unforeseeable difference, compared to the SiOxCyNz coatings is that the adhesion remains constant under wet or humid conditions, such as are the conditions for laminated beverage carton packaging.

Furthermore, and rather surprisingly, the excellent adhesion of DLC coatings at values above 200 N/m, remain unaffected also when the DLC coating is made thinner, and as thin as 2 nm, i.e. where there are actually no notable barrier properties obtained any longer. This is the case both regarding dry and wet conditions for the sample films.

When such films are laminated into packaging laminates of paperboard and thermoplastic polymer materials, it is advantageous to coat such a DLC coating on both sides of the film, in order to provide excellent adhesion on both sides of the film. Alternatively, the adhesion to adjacent layers on the opposite side of the substrate film, may be secured by a separately applied chemical primer composition, such as the 2 DEF® primer from Mitsubishi. A DLC adhesion-promoting layer is preferable from both environmental and cost perspective, since it only involves carbon atoms in the adhesion layer, and since it may be made very thin in order to just provide adhesion, or thicker in order to provide also barrier properties. At any thickness of a DLC-coating, the adhesion obtained is at least as good as that of a chemical primer (such as the 2 DEF® from Mitsubishi) under both dry and wet conditions. Application of DLC coatings onto both sides of the polymer film substrate would have to be carried out in two consecutive process steps, however.

Further Example in line with adhesion tests:

A similar BOPET film to the one used in the above Example was coated with similar thin DLC coatings on one and two sides, as described in Table 2. OTR was measured as $cc/m^2/day/atm$ at 23 °C and 50 % RH, by the same method as in the above Example. The DLC-coated films were subsequently laminated into packaging material structures including a paperboard with an outer LDPE layer, by means of a bonding layer of 15 $g/m^2$ of LDPE, and by being further coated on the opposite side of the film with an inside layer of a blend of LDPE and mLLDPE at 25 $g/m^2$. The OTR was measured on the laminated packaging material by the same method as described previously.

Subsequently, the laminated packaging materials were reformed into 1000 ml standard Tetra Brik® Aseptic packaging containers, on which the total oxygen transmission was further measured, by a Mocon 1000 equipment at 23 °C and 50 % RH. The results from the measurements are presented in table 2.

Table 2

| Test ID | Film structure | Thickness DLC 1 coating (nm) | Thickness DLC 2 coating (nm) | OTR Film (mean) | OTR packaging material (mean) | OTR Package (mean) |
|---|---|---|---|---|---|---|
| A | /BOPET/ DLC2/ | - | 3,4 | 21,8 | - | - |
| A | /DLC1/BOPET/DLC2/ | 11,9 | 3,4 | 1,1 | 1,6 | 0,037 |
| B | /BOPET/ DLC2/ | - | 3,4 | 19,3 | - | - |
| B | /DLC1/BOPET/DLC2/ | 3,5 | 3,4 | 10,5 | 1,8 | 0,027 |

Very surprisingly, it was found that when measured on laminated packaging material, and on packages from the packaging material, the oxygen barrier properties were on the same level or even improved by the film of Test B, although the film in Test B was coated with only two very thin DLC coatings, while in Test A, one of the coatings was thicker and actually intended for providing the resulting oxygen barrier properties of the film. By the measurements on the barrier-coated films, the film of Test A was indeed better, but when laminated into a final laminated packaging material structure, and used in a packaging container, both the two films were performing very well, and the film of Test B was even performing better than the film of Test A.

Thus, by the DLC-coated barrier films described above, high-integrity packaging laminates are provided, which have maintained excellent adhesion between layers also when used in liquid packaging, i.e. at subjecting the packaging material to wet conditions, and which may consequently protect other layers of the laminate from deterioration, in order to provide as good laminated material properties as possible. Since the durable DLC coatings in accordance with the invention provide both good oxygen barrier properties and water vapour barrier properties, it is a highly valuable type of barrier coating to be used in carton package laminates for liquid food products.

Further, relating to the attached figures:

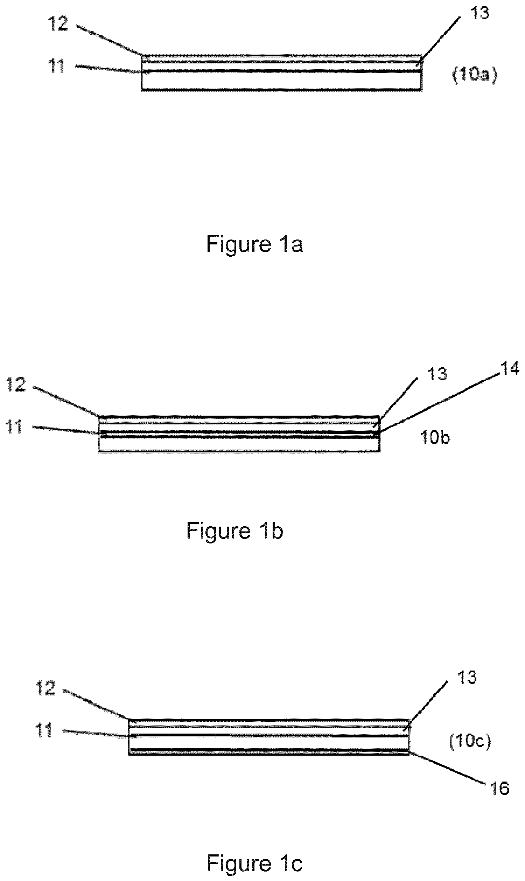

In Fig. 1a, there is shown, in cross-section, a first embodiment of a barrier film 10a, of the invention. The polymer film substrate 11 is a PET, preferably BOPET, film substrate coated with a first silicon oxide coating layer 13 having the general composition formula $SiO_XC_y$, wherein x ranges from 1.5 to 2.2 and y ranges from 0.15 to 0.80, such as from 0.39 to 0.47, and a subsequent second coating layer of an amorphous DLC coating 12, both coating layers being applied by means of vacuum plasma enhanced chemical vapour deposition, PECVD. The PECVD coatings provide the film with good oxygen barrier (low OTR value). The second DLC coating 12 is a carbon coating (C:H) which is evenly deposited to a brownish transparent coating colour. The total thickness of first and second coating layers together is frorm 7 to 10 nm, such as from 7 to 8 nm, where the first SiOxCy coating layer has a greater thickness than the second DLC coating.

In Fig. 1b, a similar polymer film substrate 11 as in Fig. 1a, a BOPET film substrate, was vacuum PECVD coated with first and second coating layers 13 and 12 as in Fig. 1a, however first pre-coated with a thin coating layer of an amorphous DLC pre-coating layer 14, also by means of vacuum PECVD coating, in order to improve the adhesion of the first coating layer to the surface of the polymer film substrate.

In Fig. 1c, a similar polymer film substrate 11 as in Fig. 1a, a BOPET film substrate, was vacuum PECVD coated with first and second coating layers 13 and 12 as in Fig. 1a. On its other side, opposite to the first and second barrier coating layers, the film substrate is PECVD coated with a thin layer of an adhesion-promoting DLC 16, in order to provide improved adhesion to adjacent polymer layers to be laminated to the barrier film on this, opposite side.

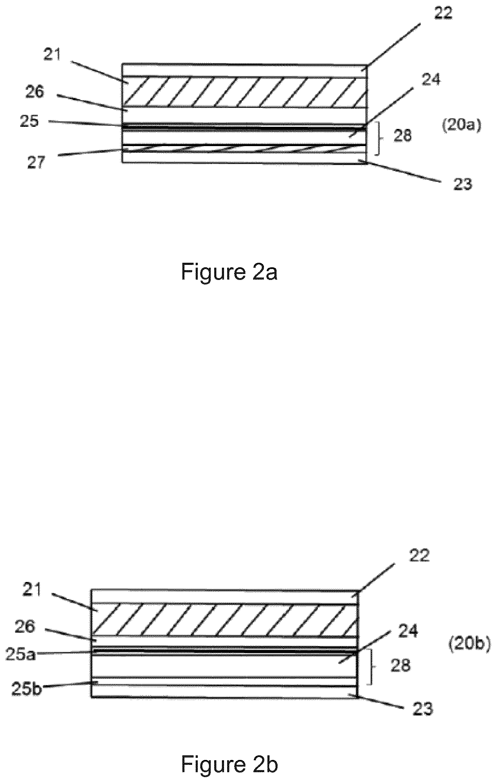

In Fig. 2a, a laminated packaging material 20a of the invention, for liquid carton packaging, is shown, in which the laminated material comprises a paperboard bulk layer 21 of paperboard, having a bending force of 320 mN, and further comprises an outer liquid tight and heat sealable layer 22 of polyolefin applied on the outside of the bulk layer 21, which side is to be directed towards the outside of a packaging container produced from the packaging laminate. The polyolefin of the outer layer 22 is a conventional low density polyethylene (LDPE) of a heat sealable quality, but may include further similar polymers, including LLDPEs. An innermost liquid tight and heat sealable layer 23 is arranged on the opposite side of the bulk layer 21, which is to be directed towards the inside of a packaging container produced from the packaging laminate, i.e. the layer 23 will be in direct contact with the packaged product. The thus innermost heat sealable layer 23, which is to form the strongest seals of a liquid packaging container made from the laminated packaging material, comprises one or more in combination of polyethylenes selected from the groups consisting of LDPE, linear low density polyethylene (LLDPE), and LLDPE produced by polymerising an ethylene monomer with a C4-C8, more preferably a C6-C8, alpha-olefin alkylene monomer in the presence of a metallocene catalyst, i.e. a so called metallocene - LLDPE (m-LLDPE).

The bulk layer 21 is laminated to a durable barrier film 28a, comprising a polymer film substrate 24, which is coated on a first side with first and second coating layers 25, as in Fig. 1a. On its second, opposite, side, the polymer film substrate is pre-primed with an adhesion-promoting primer 27, in this case 2-DEF®, a polyethyleneimine-based priming composition from Mitsubishi Chemicals. The first side of the thus durable barrier-coated film 24 is laminated to the bulk layer 21 by an intermediate layer 26 of bonding thermoplastic polymer or by a functionalised polyolefin-based adhesive polymer, in this example by a low density polyethylene (LDPE). The intermediate bonding layer 26 is formed by means of extrusion laminating the bulk layer and the durable barrier film to each other. The thickness of the intermediate bonding layer 26 is preferably from 7 to 20 $\mu$m, more preferably from 12-18 $\mu$m. The innermost heat sealable layer 23 may consist of two or several part-layers of the same or different kinds of LDPE or LLDPE or blends thereof. Excellent adhesion will be obtained in the laminated material, in that the second PECVD DLC coating layer is containing substantial amounts of carbon material, which exhibits good adhesion compatibility with polymers, such as polyethylene and polyethylene-based co-polymers.

In Fig. 2b, a laminated packaging material 20b of the invention, for liquid carton packaging, is shown, in which the laminated material comprises a paperboard core layer 21, having a bending force of 320 mN, and further comprises an outer liquid tight and heat sealable layer 22 of polyolefin applied on the outside of the bulk layer 21, which side is to be directed towards the outside of a packaging container produced from the packaging laminate. The polyolefin of the outer layer 22 is a conventional low density polyethylene (LDPE) of a heat sealable quality, but may include further similar polymers, including LLDPEs. An innermost liquid tight and heat sealable layer 23 is arranged on the opposite side of the bulk layer 21, which is to be directed towards the inside of a packaging container produced from the packaging laminate, i.e. the layer 23 will be in direct contact with the packaged product. The thus innermost heat sealable layer 23, which is to form the strongest seals of a liquid packaging container made from the laminated packaging material, comprises one or more in combination of polyethylenes selected from the groups consisting of LDPE, linear low density polyethylene (LLDPE), and LLDPE produced by polymerising an ethylene monomer with a C4-C8, more preferably a C6-C8, alpha-olefin alkylene monomer in the presence of a metallocene catalyst, i.e. a so called metallocene - LLDPE (m-LLDPE).

The bulk layer 21 is laminated to a durable barrier film 28b, which is PECVD coated on both sides in accordance with Fig. 1c, thus having first and second barrier coating layers 25a as in Fig. 1a, and an adhesion-promoting DLC coating layer 25b on the opposite side of the substrate 24 polymer film, the DLC coating layers each having a thickness lower than 5 nm. The thus durable barrier coated film 28b is laminated to the bulk layer 21 by an intermediate layer 26 of bonding thermoplastic polymer or by a functionalised polyolefin-based adhesive polymer, in this example by a low density polyethylene (LDPE). The intermediate bonding layer 26 is formed by means of extrusion laminating the bulk layer and the durable barrier film to each other. The thickness of the intermediate bonding layer 26 is preferably from 7 to 20 $\mu$m, more preferably from 12-18 $\mu$m. The innermost heat sealable layer 23 may consist of two or several part-layers of the same or different kinds of LDPE or LLDPE or blends thereof. Excellent adhesion will be obtained in the laminated material, in that the PECVD-coated durable DLC barrier coating is containing substantial amounts of carbon material, which exhibits good adhesion compatibility with polymers, such as polyolefins, such as in particular polyethylene and polyethylene-based co-polymers.

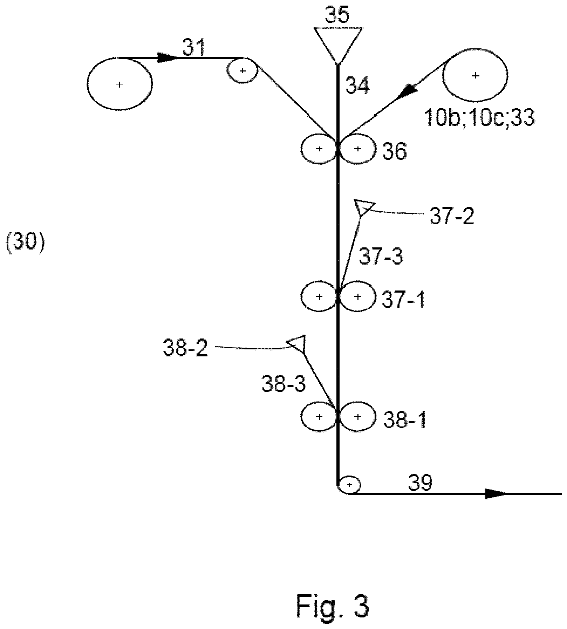

In Fig. 3, the lamination process 30 is shown, for the manufacturing of the packaging laminate 20a or 20b, of Fig. 2a and 2b, respectively, wherein the bulk layer 31 is laminated to the durable barrier film 10a or 10c (33) of Fig. 1a and 1c, by extruding an intermediate bonding layer of LDPE 34 from an extrusion station 35 and pressing together in a roller nip 36. The durable barrier film 10a; 10c; 33 has a first SiOxCy and a second DLC barrier coating layers, deposited on the surface of the polymer film substrate, whereby the DLC coating is to be directed towards the bulk layer when laminated at the lamination station 36. Subsequently, the laminated paper bulk and the barrier film passes a second extruder feedblock 37-2 and a lamination nip 37-1 , where an innermost heat sealable layer 23; 37-3 is coated onto the barrier-film side 10a; 10c of the paper-film laminate forwarded from 36. Finally, the laminate, including an innermost heat sealable layer 37-3, passes a third extruder feedblock 38-2 and a lamination nip 38-1, where an outermost heat sealable layer of LDPE 22; 38-3 is coated onto the outer side of the paper layer. This latter step may also be performed as a first extrusion coating operation before lamination at 36, according to an alternative embodiment. The finished packaging laminate 39 is finally wound onto a storage reel, not shown.

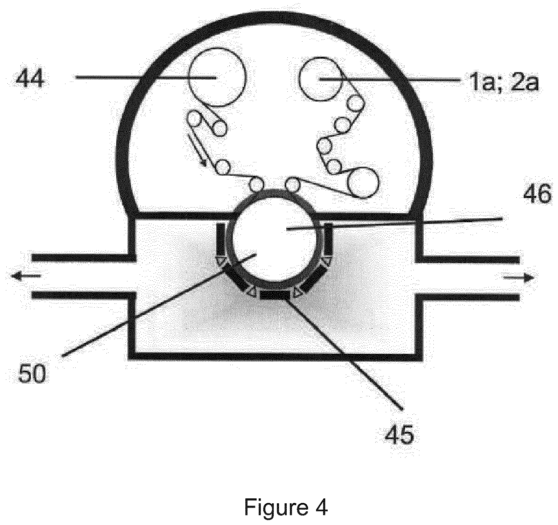

Fig. 4 is a diagrammatic view of an example of a plant for plasma enhanced vapour deposition coating, PECVD, of hydrogenated amorphous diamond-like carbon coatings onto a polymer film substrate. The film substrate 44 is subjected, on one of its surfaces, to continuous PECVD, of a plasma, 50, in a plasma reaction zone created in the space between magnetron electrodes 45, and a chilled film-transporting drum 46, which is also acting as an electrode, while the film is forwarded by the rotating drum, through the plasma reaction zone along the circumferential surface of the drum. The plasma for deposition coating of the first SiOxCy coating layer is formed from an organosilicon gas precursor composition, while the plasma for the second DLC coating layer is formed from one or more gaseous organic hydrocarbons, such as acetylene or methane, and the coatings are applied to a total thickness of 7-10 nm, preferably 7-8 nm, in two consecutive coating steps or separate plasma reaction chambers, such that the barrier film of the invention is formed.

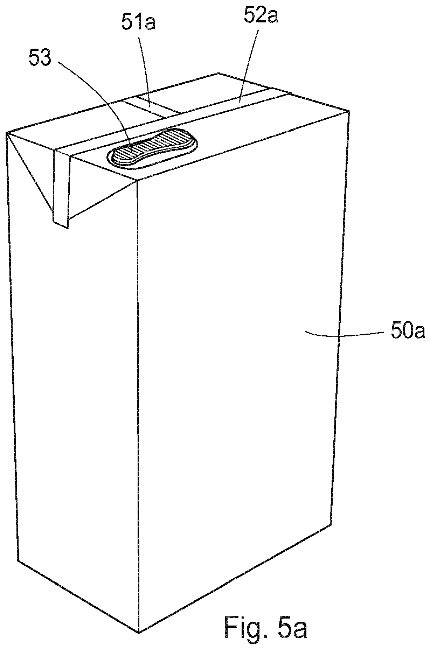

Fig. 5a shows an embodiment of a packaging container 50a produced from the packaging laminate 20 according to the invention. The packaging container is particularly suitable for beverages, sauces, soups or the like. Typically, such a package has a volume of about 100 to 1000 ml. It may be of any configuration, but is preferably brick-shaped, having longitudinal and transversal seals 51a and 52a, respectively, and optionally an opening device 53. In another embodiment, not shown, the packaging container may be shaped as a wedge. In order to obtain such a "wedge-shape", only the bottom part of the package is fold formed such that the transversal heat seal of the bottom is hidden under the triangular corner flaps, which are folded and sealed against the bottom of the package. The top section transversal seal is left unfolded. In this way the half-folded packaging container is still is easy to handle and dimensionally stable when put on a shelf in the food store or on a table or the like.

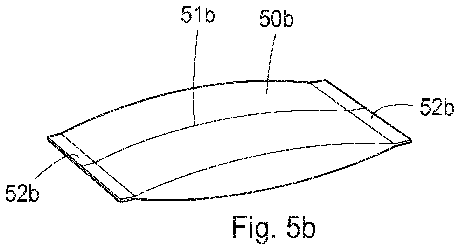

Fig. 5b shows an alternative, preferred example of a packaging container 50b produced from an alternative packaging laminate 20 according to the invention. The alternative packaging laminate is thinner by having a thinner paper bulk layer 21, and thus it is not dimensionally stable enough to form a parallellepipedic or wedge-shaped packaging container, and is not fold formed after transversal sealing 52b. It will thus remain a pillow-shaped pouch-like container and be distributed and sold in this form.

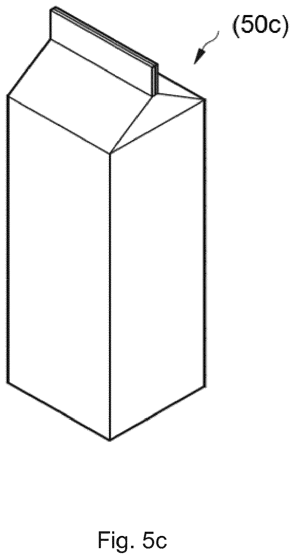

Fig. 5c shows a gable top package 50c, which is fold-formed from a pre-cut sheet or blank, from the laminated packaging material comprising a bulk layer of paperboard and the durable barrier film of the invention. Also flat top packages may be formed from similar blanks of material.

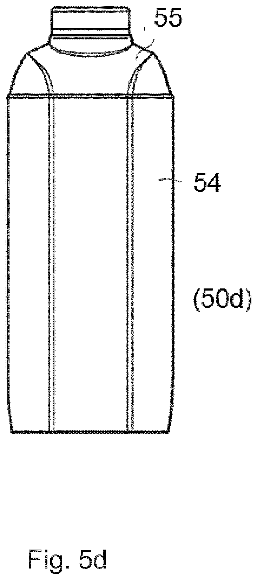

Fig. 5d shows a bottle-like package 50d, which is a combination of a sleeve 54 formed from a pre-cut blanks of the laminated packaging material of the invention, and a top 55, which is formed by injection moulding plastics in combination with an opening device such as a screw cork or the like. This type of packages are for example marketed under the trade names of Tetra Top® and Tetra Evero®. Those particular packages are formed by attaching the moulded top 55 with an opening device attached in a closed position, to a tubular sleeve 54 of the laminated packaging material, sterilizing the thus formed bottle-top capsule, filling it with the food product and finally fold-forming the bottom of the package and sealing it.

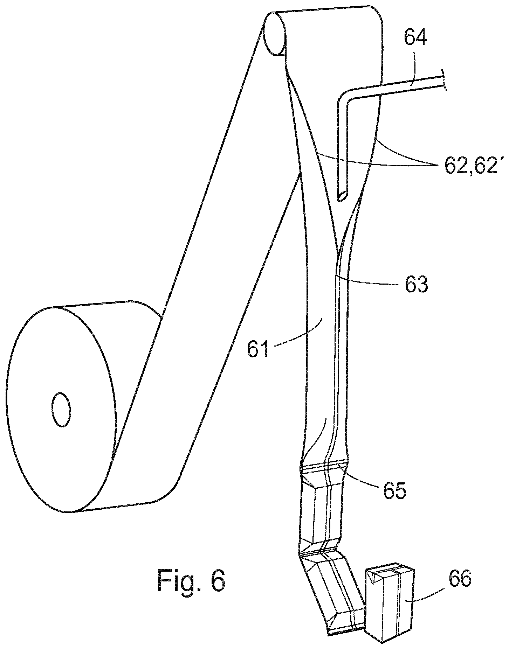

Fig. 6 shows the principle as described in the introduction of the present application, i.e. a web of packaging material is formed into a tube 61 by the longitudinal edges 62 of the web being united to one another in an overlap joint 63. The tube is filled 64 with the intended liquid food product and is divided into individual packages by repeated transversal seals 65 of the tube at a pre-determined distance from one another below the level of the filled contents in the tube. The packages 66 are separated by incisions in the transversal seals and are given the desired geometric configuration by fold formation along prepared crease lines in the material.

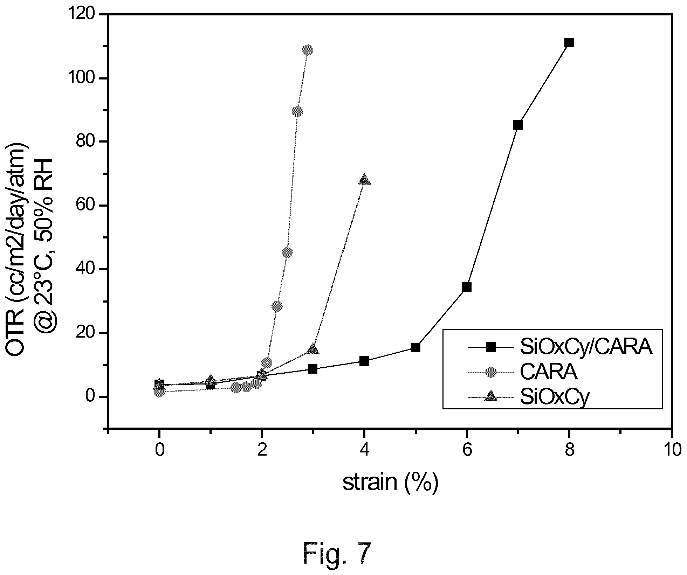

Fig. 7 shows a diagram of the OTR of three BOPET substrate polymer films, each being coated with three different vacuum PECVD coatings, as a fucntion of the strain of the film, and indicating and comparing the point of crack onset strain for each film, i.e. the point of strain at which the oxygen barrier properties begin to deteriorate beyond being useful in a barrier film. The diagram shows that a COS of about 2% or above, may be obtained with a good amorphous DLC coating by PECVD under vaccum. With a good silicon oxide coating, having a general composition formula SiOx or SiOxCy wherein x ranges from 1.5 to 2.2, by PECVD under vacuum, a COS of about 3-4 % may be obtained by coating onto a similar film. However, when vacuum-coating by PECVD a similar PET-based film with a first coating of SiOxCy, followed by a coating of amorphous DLC, the COS is synergetically improved to a value of 5-6 % and above, and in addition, it seems that the total coating thickness may be thinner, while still achieving the same level of barrier properties as compared to comparable, but thicker, single-layer coatings. In some cases, a COS of from 7 to 8 % was achieved for similar films having the combined first and second coating layers. The particular example films behind the diagram were coated BOPET films of thickness 12 $\mu$m, but similar COS values were for example also obtained for biaxially oriented films of polypropylene (BOPP) having a thin coating-receiving layer of polyamide, such as from 1-2 $\mu$m thick.

As a final remark, the invention is not limited by the embodiments shown and described above, but may be varied within the scope of the claims.

**Claims**

1. Laminated packaging material for liquid food products (20), comprising a barrier film (28), a first outermost liquid tight, heat sealable polyolefin layer (22) and a second innermost liquid tight, heat sealable polyolefin layer (23), the barrier film comprising a polymer film substrate (24) and coated onto a first side of the polymer film substrate, by plasma-enhanced chemical vapour deposition (PECVD) in a vacuum process, a first coating layer of silicon oxide having the general composition formula SiOxCy, wherein x is from 1.5 to 2.2, and y is from 0.15 to 0.8, and a second coating layer of an amorphous diamond-like carbon (DLC), which is directly adjacent and contacting the first coating layer, wherein the total thickness of the first and second coating layers (25a) is from 7 to 10 nm, the barrier film (28) providing gas and water vapour barrier properties and mechanical durability in the laminated packaging material and packages made thereof.

2. Laminated packaging material as claimed in claim 1, wherein x is from 1.7 to 2.1, and y is from 0.39 to 0.47.

3. Laminated packaging material as claimed in any one of claims 1-2, wherein the polymer film substrate is selected from the group consisting of films based on any of polyesters, such as polyethylene terephthalate (PET), mono- or biaxially oriented PET (OPET, BOPET), non- or mono- or biaxially oriented polyethylenefuranoate (PEF), oriented or non-oriented polybutylene terephthalate (PBT), polyethylene napthanate (PEN), polyamides, such as, non-oriented or oriented polyamide (PA, OPA, BOPA), ethylene vinyl alcohol copolymers (EVOH), polyolefins such as polypropylene, mono- or biaxially oriented polypropylene (PP, OPP, BOPP), polyethylenes such as oriented or non-oriented high density polyethylene (HDPE), linear low density polyethylene (LLDPE) and cyclo-olefin co-polymers (COC), and blends of any of said polymers, or a multilayer film having a surface layer comprising any of said polymers or blends thereof.

4. Laminated packaging material as claimed in any one of claims 1-3, wherein the polymer film substrate is a film selected from the group consisting of films based on any of polyethylene terephthalate (PET), mono-or biaxially oriented PET (OPET, BOPET), oriented or non- oriented polybutylene terephthalate (PBT), non- or mono- or biaxially oriented polyethylene furanoate (PEF), polyethylene napthanate (PEN), non-oriented polyamide or oriented polyamide (PA, OPA, BOPA) or blends of two or more of said polymers, and multilayer films having a surface layer comprising such polymers or blends thereof.

5. Laminated packaging material as claimed in any one of claims 1-4, wherein a pre-coating layer of an amorphous DLC is first applied directly adjacent and in direct contact with the surface of the polymer film substrate, and further coated on its free side with said first coating layer.

6. Laminated packaging material as claimed in any one of claims 1-5, wherein the polymer film substrate (24) has an adhesion-promoting primer coating (25b) of amorphous DLC on its other, uncoated side.

7. Laminated packaging material according to any one of Claims 1-6, wherein the first coating layer of silicon oxide is from 4 to 8 nm thick and thicker than the second DLC coating layer, which is from 2 to 4 nm thick.

8. Laminated packaging material according to any one of Claims 1-7, wherein the barrier film (28) has a crack-onset strain of 5 % or higher.

9. Laminated packaging material according to any one of claims 1-8, further comprising a bulk layer (21) of paper or paperboard or other cellulose-based material, a first outermost liquid tight, heat sealable polyolefin layer (22), a second innermost liquid tight, heat sealable polyolefin layer (23) and, arranged on the inner side of the bulk layer of paper or paperboard, between the bulk layer and the innermost layer, said barrier film (28).

10. Laminated packaging material according to claim 9, wherein the barrier film (28) is bonded to the bulk layer (21) by an intermediate thermoplastic polymer bonding layer (26), binding the surface of the second barrier coating layer of DLC to the bulk layer.

11. Laminated packaging material according to claim 10, wherein the polymer film substrate (24) of the barrier film (28) has an adhesion-promoting primer coating of amorphous DLC (25b) on its other side, opposite the side coated with the first and second barrier coating layers (25a), and wherein the barrier film is bonded to the second innermost liquid tight, heat sealable polyolefin layer by means of the adhesion-promoting primer coating of amorphous DLC (25b).

12. Packaging container comprising the laminated packaging material as defined in any one of claims 1-11.

**Patentansprüche**

1. Laminiertes Verpackungsmaterial für flüssige Nahrungsmittelprodukte (20), umfassend einen Barrierefilm (28), eine erste äußerste flüssigkeitsdichte, heißsiegelbare Polyolefinschicht (22) und eine zweite innerste flüssigkeitsdichte, heißsiegelbare Polyolefinschicht (23), wobei der Barrierefilm ein Polymerfilmsubstrat (24) umfasst, und auf einer ersten Seite des Polymerfilmsubstrats durch plasmagestützte chemische Gasphasenabscheidung (PECVD) in einem Vakuumprozess als Beschichtung eine erste Beschichtungsschicht aus Siliciumoxid mit der allgemeinen Zusammensetzungsformel $SiO_xC_y$, wobei x 1,5 bis 2,2 beträgt, und y 0,15 bis 0,8 beträgt, und eine zweite Beschichtungsschicht aus amorphen diamantartigem Kohlenstoff (DLC) aufgebracht ist, die direkt benachbart der ersten Beschichtungsschicht ist und in Kontakt mit ihr ist, wobei die Gesamtdicke der ersten und zweiten Beschichtungsschichten (25a) 7 bis 10 nm beträgt, wobei der Barrierefilm (28) dem laminierten Verpackungsmaterial und daraus gefertigten Verpackungen Gas- und Wasserdampfbarriereeigenschaften und mechanische Dauerhaftigkeit bereitstellt.

2. Laminiertes Verpackungsmaterial nach Anspruch 1, wobei x 1,7 bis 2,1 beträgt und y 0,39 bis 0,47 beträgt.

3. Laminiertes Verpackungsmaterial nach einem der Ansprüche 1 bis 2, wobei das Polymerfilmsubstrat ausgewählt ist aus der Gruppe bestehend aus Filmen, die auf beliebigen von Polyestern, wie Polyethylenterephthalat (PET), mono- oder biaxial orientiertem PET (OPET, BOPET), nicht- oder mono- oder biaxial orientiertem Polyethylenfuranoat (PEF), orientiertem oder nicht-orientiertem Polybutylenterephthalat (PBT), Polyethylennapthanat (PEN), Polyamiden, wie nicht-orientiertem oder orientiertem Polyamid (PA, OPA, BOPA), Ethylen-Vinylalkohol-Copolymeren (EVOH), Polyolefinen, wie Polypropylen, mono- oder biaxial orientiertem Polypropylen (PP, OPP, BOPP), Polyethylenen, wie orientiertem oder nicht-orientiertem Polyethylen mit hoher Dichte (HDPE), linearem Polyethylen mit niedriger Dichte (LLDPE) und Cycloolefincopolymeren (COC) sowie Gemischen von beliebigen dieser Polymere oder einem Mehrschichtfilm mit einer Oberflächenschicht basieren, die beliebige dieser Polymere oder Gemische davon umfasst.

4. Laminiertes Verpackungsmaterial nach einem der Ansprüche 1 bis 3, wobei das Polymerfilmsubstrat ein Film ausgewählt aus der Gruppe bestehend aus Filmen ist, die auf jedweden von Polyethylenterephthalat (PET), mono- oder biaxial orientiertem PET (OPET, BOPET), orientiertem oder nicht-orientiertem Polybutylenterephthalat (PBT), nicht- oder mono- oder biaxial orientiertem Polyethylenfuranoat (PEF), Polyethylennaphthanat (PEN), nicht-orientiertem Polyamid oder orientiertem Polyamid (PA, OPA, BOPA) oder Gemischen von zwei oder mehr Polymeren basieren, oder ein Mehrschichtfilm mit einer Oberflächenschicht ist, die jedwedes dieser Polymere oder Gemische davon umfasst.

5. Laminiertes Verpackungsmaterial nach einem der Ansprüche 1 bis 4, wobei eine Vorbeschichtungsschicht aus amorphem DLC zuerst direkt benachbart zu und in direktem Kontakt mit der Oberfläche des Polymerfilmsubstrats aufgebracht wird und auf seiner freien Seite weiter mit der ersten Beschichtungsschicht beschichtet wird.

6. Laminiertes Verpackungsmaterial nach einem der Ansprüche 1 bis 5, wobei das Polymerfilmsubstrat (24) eine adhäsionsfördernde Grundierungsbeschichtung (25b) aus amorphem DLC auf seiner anderen unbeschichteten Seite aufweist.

**7.** Laminiertes Verpackungsmaterial nach einem der Ansprüche 1 bis 6, wobei die erste Beschichtungsschicht aus Siliciumoxid 4 bis 8 nm dick ist und dicker als die zweite DLC-Beschichtungsschicht ist, die 2 bis 4 nm dick ist.

**8.** Laminiertes Verpackungsmaterial nach einem der Ansprüche 1 bis 7, wobei der Barrierefilm (28) eine Rissbeginnspannung (Crack-onset Strain, COS) von 5 % oder höher aufweist.

**9.** Laminiertes Verpackungsmaterial nach einem der Ansprüche 1 bis 8, des Weiteren umfassend eine Massenschicht (21) aus Papier oder Karton oder sonstigem Material auf Cellulosebasis, eine erste äußerste flüssigkeitsdichte, heißsiegelbare Polyolefinschicht (22), eine zweite innerste flüssigkeitsdichte, heißsiegelbare Polyolefinschicht (23), und angeordnet auf der Innenseite der Massenschicht aus Papier und Karton zwischen der Massenschicht und der innersten Schicht den Barrierefilm (28) .

**10.** Laminiertes Verpackungsmaterial nach Anspruch 9, wobei der Barrierefilm (28) über eine thermoplastische Zwischenpolymerbindungsschicht (26) an die Massenschicht (21) gebondet ist, wodurch die Oberfläche der zweiten Barrierebeschichtungsschicht aus DLC an die Massenschicht bindet.

**11.** Laminiertes Verpackungsmaterial nach Anspruch 10, wobei das Polymerfilmsubstrat (24) des Barrierefilms (28) eine adhäsionsfördernde Grundierungsbeschichtung aus amorphem DLC (25b) auf seiner anderen Seite aufweist, die der Seite gegenüber liegt, die mit den ersten und zweiten Barrierebeschichtungsschichten (25a) beschichtet ist, und wobei der Barrierefilm mittels der adhäsionsfördernden Grundierungsbeschichtung aus amorphem DLC (25b) an die zweite innerste flüssigkeitsdichte, heißsiegelbare Polyolefinschicht gebondet ist.

**12.** Verpackungsbehälter, umfassend das laminierte Verpackungsmaterial gemäß einem der Ansprüche 1 bis 11.


**Revendications**

**1.** Matériau d'emballage stratifié pour des produits alimentaires liquides (20), comprenant un film barrière (28), une première couche (22) de polyoléfine étanche aux liquides, thermoscellable la plus à l'extérieur et une deuxième couche (23) de polyoléfine étanche aux liquides, thermoscellable la plus à l'intérieur, le film barrière comprenant un substrat (24) de film de polymère et revêtues sur un premier côté du substrat de film de polymère, par dépôt chimique en phase vapeur activé par plasma (PECVD) dans un procédé sous vide, une première couche de revêtement d'oxyde de silicium possédant la formule de composition générale SiOxCy, x étant de 1,5 à 2,2, et y étant de 0,15 à 0,8, et une deuxième couche de revêtement composée d'un carbone de type diamant amorphe (DLC), qui est directement adjacente et est en contact avec la première couche de revêtement, l'épaisseur totale des première et deuxième couches de revêtement (25a) étant de 7 à 10 nm, le film barrière (28) fournissant des propriétés de barrière aux gaz et à la vapeur d'eau et une durabilité mécanique dans le matériau d'emballage stratifié et des emballages fabriqués à partir de celui-ci.

**2.** Matériau d'emballage stratifié selon la revendication 1, x étant de 1,7 à 2,1, et y étant de 0,39 à 0,47.

**3.** Matériau d'emballage stratifié selon l'une quelconque des revendications 1 et 2, le substrat de film de polymère étant choisi dans le groupe constitué par des films à base d'un quelconque parmi des polyesters, tels que le poly(téréphtalate d'éthylène) (PET), un PET orienté de manière monoaxiale ou biaxiale (OPET, BOPET), un poly(furannoate d'éthylène) non orienté ou orienté de manière monoaxiale ou biaxiale (PEF), un poly(téréphtalate de butylène) orienté ou non orienté (PBT), un poly(naphtanate d'éthylène) (PEN), des polyamides, tels que, un polyamide non orienté ou orienté (PA, OPA, BOPA), des copolymères d'éthylène-alcool vinylique (EVOH), des polyoléfines telles qu'un polypropylène, un polypropylène orienté de manière monoaxiale ou biaxiale (PP, OPP, BOPP), des polyéthylènes tels qu'un polyéthylène à haute densité orienté ou non orienté (HDPE), un polyéthylène basse densité linéaire (LLDPE) et des co-polymères de cyclo-oléfine (COC), et des mélanges de quelconques parmi lesdits polymères, ou un film multicouche possédant une couche de surface comprenant l'un quelconque parmi lesdits polymères ou mélanges correspondants.

**4.** Matériau d'emballage stratifié selon l'une quelconque des revendications 1 à 3, le substrat de film de polymère étant un film choisi dans le groupe constitué par des films à base d'un quelconque parmi un poly(téréphtalate d'éthylène) (PET), un PET orienté de manière monoaxiale ou biaxiale (OPET, BOPET), un poly(téréphtalate de butylène) orienté ou non orienté (PBT), un poly(furannoate d'éthylène) non orienté ou orienté de manière monoaxiale ou biaxiale (PEF), un poly(naphtanate d'éthylène) (PEN), un polyamide non orienté ou un polyamide orienté (PA, OPA, BOPA) et des mélanges de deux ou plus desdits polymères, et des films multicouches possédant une couche de surface comprenant de tels polymères ou mélanges correspondants.

**5.** Matériau d'emballage stratifié selon l'une quelconque des revendications 1 à 4, une couche de pré-revêtement composée d'un DLC amorphe étant d'abord appliquée de manière directement adjacente et en contact direct avec la surface du substrat de film de polymère, et en outre revêtue sur son côté libre avec ladite première couche de revêtement.

**6.** Matériau d'emballage stratifié selon l'une quelconque des revendications 1 à 5, le substrat (24) de film de polymère possédant un revêtement (25b) d'apprêt favorisant l'adhérence composé de DLC amorphe sur son autre côté non revêtu.

**7.** Matériau d'emballage stratifié selon l'une quelconque des revendications 1 à 6, la première couche de revêtement d'oxyde de silicium étant d'une épaisseur de 4 à 8 nm et étant plus épaisse que la deuxième couche de revêtement de DLC, qui est d'une épaisseur de 2 à 4 nm.

**8.** Matériau d'emballage stratifié selon l'une quelconque des revendications 1 à 7, le film barrière (28) possédant une contrainte de début de formation de fissures de 5 % ou plus.

**9.** Matériau d'emballage stratifié selon l'une quelconque des revendications 1 à 8, comprenant en outre une couche massive (21) de papier ou de carton ou d'un autre matériau à base de cellulose, une première couche (22) de polyoléfine étanche aux liquides, thermoscellable la plus à l'extérieur, une deuxième couche (23) de polyoléfine étanche aux liquides, thermoscellable la plus à l'intérieur, et, agencé sur le côté intérieur de la couche massive de papier ou de carton, entre la couche massive et la couche la plus à l'intérieur, ledit film barrière (28).

**10.** Matériau d'emballage stratifié selon la revendication 9, le film barrière (28) étant lié à la couche massive (21) par une couche (26) de liaison de polymère thermoplastique intermédiaire, liant la surface de la deuxième couche de revêtement barrière composée de DLC à la couche massive.

**11.** Matériau d'emballage stratifié selon la revendication 10, le substrat (24) de film de polymère du film barrière (28) possédant un revêtement d'apprêt favorisant l'adhérence composé de DLC amorphe (25b) sur son autre côté, opposé au côté revêtu avec les première et deuxième couches de revêtement barrière (25a), et le film barrière étant lié à la deuxième couche de polyoléfine étanche aux liquides, thermoscellable la plus à l'intérieur au moyen du revêtement d'apprêt favorisant l'adhérence composé de DLC amorphe (25b).

**12.** Récipient d'emballage comprenant le matériau d'emballage stratifié tel que défini dans l'une quelconque des revendications 1 à 11.

Figure 1a

Figure 1b

Figure 1c

Figure 2a

Figure 2b

Fig. 3

Figure 4

Fig. 5a

51b 50b

52b

52b

Fig. 5b

(50c)

Fig. 5c

55

54

(50d)

Fig. 5d

EP 3 615 707 B1

Fig. 6

27

Fig. 7

EP 3 615 707 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005088452 A
- JP 2008094447 A
- US 20020028336 A
- US 7806981 B